Europäisches Patentamt

European Patent Office

Office européen des brevets

(11) Publication number: **0 117 081**
**B1**

## EUROPEAN PATENT SPECIFICATION

(45) Date of publication of patent specification: **24.05.89**

(51) Int. Cl.⁴: **H 03 H 9/44**

(21) Application number: **84300571.1**

(22) Date of filing: **30.01.84**

(54) Surface acoustic wave dispersive delay lines.

(30) Priority: **31.01.83 JP 14192/83**

(43) Date of publication of application:
**29.08.84 Bulletin 84/35**

(45) Publication of the grant of the patent:
**24.05.89 Bulletin 89/21**

(84) Designated Contracting States:
**FR GB NL**

(56) References cited:
**GB-A-1 474 605**
**US-A-3 883 831**

(73) Proprietor: **NEC CORPORATION**
**33-1, Shiba 5-chome, Minato-ku**
**Tokyo 108 (JP)**

(72) Inventor: **Watanabe, Takaya**
**c/o NEC Corporation 33-1 Shiba 5-chome**
**Minato-ku Tokyo 108 (JP)**
Inventor: **Kitano, Toshihiko**
**c/o NEC Corporation 33-1 Shiba 5-chome**
**Minato-ku Tokyo 108 (JP)**

(74) Representative: **Orchard, Oliver John**
**JOHN ORCHARD & CO. Staple Inn Buildings**
**North High Holborn**
**London WC1V 7PZ (GB)**

Courier Press, Leamington Spa, England.

## Description

### Background of the Invention

This invention relates to a reflection grating type surface acoustic wave dispersive delay line.

As is disclosed in US—A—3,883,831, the prior art dispersive type delay line is constituted by an input transducer for generating surface acoustic wave, a first reflector made up of a plurality of reflection gratings that reflect surface acoustic wave radiated from the input transducer in an orthogonal direction, a second transducer made up of a plurality of reflection gratings which reflect again the reflected wave in an orthogonal direction, and an output transducer which converts the surface acoustic wave reflected by the second reflector into the original electric signal. In the reflection grating type surface acoustic wave dispersive delay line of this type, however, there is a defect that the amplitude of the electric signal converted at the output transducer overshoots on the side of the pass bandwith of the frequency/amplitude characteristic. Furthermore, near a frequency at which the overshooting occurs, delay time and phase of the output electric signal varies greatly.

In this prior patent, a conductive layer 17 is provided, in one embodiment, at such a distance along the 2 axis and of such a width that compensation is provided for phase error which may occur at a particular frequency in the absence of the layer.

In GB—A—1474605, there is also a disclosure of metal layers 15 and 16 which are shaped in order to adjust the phase of a signal at a particular frequency in order to correct phase errors.

There is no suggestion in either of these prior patents that means should be provided for minimising any concentration of a surface acoustic wave that may tend to occur at an area of focus which corresponds to a focal point of a phantom lens which is constituted by the first and second reflectors.

It is an object of this invention to provide an improved reflection grating type surface acoustic wave dispersive delay line that can minimise the overshoot of the signal that tends to occur at the output transducer by minimising the concentration of a surface acoustic wave at a particular area of focus.

The present invention is defined in claim 1, and it employs means for minimising any concentration of the surface wave that may tend to occur at an area of focus corresponding to a focal length of a phantom lens.

The concentration minimising means is formed, in an embodiment to be described, by coating a conductive composition or a silicon rubber on a focal point or focus at which the surface acoustic wave concentrates, or by irradiating the focal point with a laser beam.

### Brief Description of the Drawing

In the accompanying drawing:

Fig. 1 is a diagrammatic representation of one embodiment of the surface acoustic wave dispersive delay line according to this invention; and

Fig. 2 shows the frequency/amplitude characteristic of the delay line shown in Fig. 1.

### Description of the Preferred Embodiment

The principle of this invention will be described first. The delay line of this invention is based on the following principle. More particularly, in a metal grating type dispersive delay line comprising a plurality of reflection gratings, the surface acoustic wave impinging upon the reflection gratings ideally follows Snell's law when mode conversion is neglected. Actually, however, since the piezoelectric substrate used has anisotropic properties, the surface acoustic wave is radiated in all directions instead of in an orthogonal direction at a portion where the wavelength of the surface acoustic wave coincides with the pitch (spacing between adjacent reflection gratings) of a plurality of reflection gratings.

For this reason, a plurality of reflection gratings having different pitches and successively juxtaposed operate like a Fresnel lens, thus concentrating the surface acoustic wave to a specific point along the propagation path of the surface acoustic wave with the result that the amplitude and phase of the propagating surface acoustic wave are disturbed. This invention contemplates elimination of the focal point of the wavefront acting as a lens. In other words, according to this invention, means is provided to prevent concentration of the surface acoustic wave to one point at which the characteristic is disturbed.

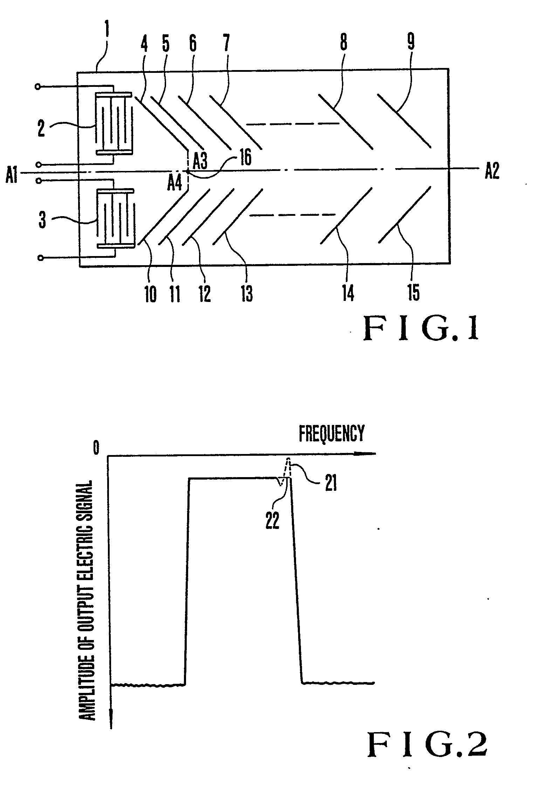

A preferred embodiment of the surface acoustic wave dispersive delay line of this invention shown in Fig. 1 comprises a piezoelectric substrate 1 made of lithium neobate (LiNbO$_3$), quartz (SiO$_2$) or bismuth germanium oxide (Bi$_{12}$GeO$_{20}$). An input transducer 2 converts an input electric signal into a surface acoustic wave signal, while an output transducer 3 converts the surface acoustic wave signal back into the electric signal. Each of the input and output transducers 2 and 3 is constituted by interdigital electrodes. Reflection gratings 4 through 9 are used to bend the surface acoustic wave in the orthogonal direction and is made of such metal as aluminum or oxide thereof. Reflection gratings 10 through 15 are in axial symmetry with the reflection gratings 4 through 9 with respect to a phantom axis A1A2 (a line interconnecting the cross-points of the reflection gratings 10 through 15 and 4 through 9). It was confirmed by experiment that the mid point 16 of a phantom axis A3A4 corresponded to a focal point or focus. In the dispersive delay line having the construction described above, when a surface acousting wave is radiated from the input transducer 1, the surface acoustic wave propagates through reflectors 4 to 9 and the almost portion of the propagating surface acoustic wave sharply reflects in the orthogonal direction at a point at which the wavelength of the surface acoustic wave and the distance between the adjacent reflection gratings (reflector pitch) coini- cide with each other. The propagating surface acoustic wave is reflected again in the orthogonal direction at the reflection gratings 10 to 15 to reach the output transducer 3. However, owing to the anisotropic property of the piezoelectric substrate for the surface acoustic wave, a portion of the surface acoustic wave concentrates to the center point of the phantom axis A3A4.

Consequently, an overshooting phenomenon as shown at 21 in Fig. 2 appears in the delay characteristic of the output electric signal near a point 22 on a higher frequency side of the passband of the frequency/amplitude characteristic. For this reason, according to the delay line of this invention, a surface acoustic wave absorbing member made of a conductive composition or a silicon rubber is coated on the mid point of the phantom axis A3A4 for eliminating overshooting of the amplitude of the output electric signal caused by the surface wave concentrating to the mid point or focal point.

Preferably, the elastic surface wave absorbing member is made of such a sound absorbing material as a conductive composition agent or a silicon rubber. Instead of coating the surface acoustic wave absorbing material, a portion of the substrate at which the focus is formed can be irradiated with a laser beam for disturbing the propagation of the surface acoustic wave.

As described above, according to this invention, the overshooting of the output electric signal in the delay characteristic can be efficiently prevented by a simple measure of applying a surface acoustic wave absorbing material to the focus at which the surface wave concentrates or by irradiating the focus with a laser beam. It should be understood that this invention is also applicable to a group reflector structure formed by ion beam etching in addition to the reflector of metal reflection gratings.

## Claims

1. A surface acoustic wave dispersive delay line including a substrate (1) along which a surface acoustic wave may propagate, and input transducer (2) formed on the substrate for producing an acoustic wave in response to an input electric signal, a first reflector having a plurality of parallel reflection gratings (1—9) each grating being of substantially uniform dimensions and being formed with different spaces between them on the substrate (1) for reflecting a surface acoustic wave output from the input transducer (2) at a first preselected angle of reflection, a second reflector having a plurality of parallel reflection gratings (10—15) each grating being of substantially uniform dimensions and being formed with different spaces between them on the substrate (1) for reflecting a surface acoustic wave reflected by the first reflector at a second preselected angle of reflection, and an output transducer (3) for converting the surface acoustic wave reflected by the second reflector (10—15) into an electric signal, characterised in that means is provided for minimising any concentration of the surface acoustic wave which tends to occur at an area of focus corresponding to a focal point of a phantom lens constituted by the first (1—9) and second (10—15) reflectors.

2. A delay line as claimed in claim 1 characterised in that the substrate (1) is made of piezoelectric material.

3. A delay line as claimed in claim 1 characterised in that the concentration minimising means includes a coating of a conductive composition applied on the area of focus at which the surface acoustic wave concentrates.

4. A delay line as claimed in claim 1 characterised in that the concentration minimising means includes a coating of a silicon rubber applied on the area of focus at which the surface acoustic wave concentrates.

5. A delay line as claimed in claim 1 characterised in that the concentration minimising means is formed by irradiating with a laser beam the area of focus at which the surface acoustic wave concentrates.

## Patentansprüche

1. Dispersive Verzögerungsleitung für akustische Oberflächenwellen mit einem Substrat (1), an dem sich eine akustische Oberflächenwelle ausbreiten kann, einem auf dem Substrat ausgebildeten Eingangswandler (2) zum Erzeugen einer akustischen Welle als Antwort auf ein elektrisches Eingangssignal, einem ersten Reflektor mit mehreren parallelen Reflektionsgittern (1—9), wobei jedes Gitter im wesentlichen einheitliche Abmessungen aufweist und mit verschiedenen Abständen voneinander auf dem Substrat (1) ausgebildet ist, zum Reflektierten einer von dem Eingabewandler (2) ausgegebenen akustischen Oberflächenwelle bei einem ersten ausgewählten Reflektionswinkel, einem zweiten Reflektor mit mehreren parallelen Reflektionsgittern (10—15), wobei jedes Gitter im wesentlichen einheitliche Abmessungen aufweist und mit verschiedenen Abständen voneinander auf dem Substrat (1) ausgebildet ist, zum Reflektieren, akustischen Oberflächenwelle bei einem zweiten ausgewählten Reflektionswinkel und mit einem Ausgangswandler (3) zum Wandeln der von dem zweiten Reflektor (10—15) reflektierten, akustischen Oberflächenwelle in ein elektrisches Signal, dadurch gekennzeichnet, daß eine Einrichtung vorgesehen ist zum Verringern einer Konzentration der akustischen Oberflächenwelle, die in einem Fokussierbereich auftreten kann, der einem Brennpunkt einer durch die ersten (1—9) und zweiten (10—15) Reflektoren gebildeten Phantomlinsen entspricht.

2. Verzögerungsleitung nach Anspruch 1, dadurch gekennzeichnet, daß das Substrat (1) aus piezoelektrischem Material hergestellt ist.

3. Verzögerungsleitung nach Anspruch 1, dadurch gekennzeichnet, daß die Einrichtung zum Verringern der Konzentration eine Beschichtung aus einer leitenden Zusammensetzung aufweist, die auf dem Fokussierbereich, an dem sich die akustische Oberflächenwelle konzentriert, aufgebracht wird.

4. Verzögerungsleitung nach Anspruch 1, dadurch gekennzeichnet, daß die Einrichtung zum Verringern der Konzentration eine Beschichtung aus einem Silikonkautschuk aufweist, die auf dem Fokussierbereich, an dem sich die akustische Oberflächenwelle konzentriert, aufgebracht wird.

5. Verzögerungsleitung nach Anspruch 1, dadurch gekennzeichnet, daß die Einrichtung zum Verringern der Konzentration gebildet wird durch Bestrahlen des Fokussierbereichs an dem sich die akustische Oberflächenwelle konzentriert mit einem Laserstrahl.

**Revendications**

1. Ligne à retard dispersive à ondes acoustiques de surface comprenant un substrat (1) le long duquel une onde acoustique de surface peut se propager, et un transducteur d'entrée (2) formé sur le substrat pour produire une onde acoustique en réponse à un signal électrique d'entrée, un premier réflecteur ayant une multitude de réseaux parallèles de réflexion (1—9), les réseaux ayant chacun des dimensions sensiblement uniformes et présentant des espaces différents entre eux sur le substrat (1) pour réfléchir une onde acoustique de surface sortant du transducteur d'entrée (2) à un premier angle présélectionné de réflexion, un second réflecteur ayant une multitude de réseaux parallèles de réflexion (10—15), les réseaux ayant chacun des dimensions sensiblement uniformes et présentant des espaces différents entre eux sur le substrat (1) pour réflexion d'une onde acoustique de surface réfléchie par le premier réflecteur à un second angle présélectionné de réflexion, et un transducteur de sortie (3) pour convertir l'onde acoustique de surface réfléchie par le second réflecteur (10—15) en signal électrique, caractérisée en ce qu'un moyen est prévu pour minimiser toute concentration de l'onde acoustique de surface qui a tendance à se produire à une zone de foyer correspondant au foyer d'une lentille fantôme constituée par les premier (1—9) et second (10—15) réflecteurs.

2. Ligne à retard selon la revendication 1, caractérisée en ce que le substrat (1) est en matériau piézoélectrique.

3. Ligne à retard selon la revendication 1, caractérisée en ce que le moyen minimisant la concentration comporte un revêtement d'une composition conductrice appliquée à la zone du foyer à laquelle se concentre l'onde acoustique de surface.

4. Ligne à retard selon la revendication 1, caractérisée en ce que le moyen minimisant la concentration comporte un revêtement de caoutchouc de silicone appliqué à la zone du foyer à laquelle se concentre l'onde acoustique de surface.

5. Ligne à retard selon la revendication 1, caractérisée en ce que le moyen minimisant la concentration est formé par irradiation avec un faisceau laser de la zone du foyer à laquelle se concentre l'onde acoustique de surface.

FIG.1

FIG.2

1